# EUROPÄISCHE PATENTSCHRIFT

(11) **EP 1 993 132 B1**
(45) Veröffentlichungstag und Bekanntmachung des Hinweises auf die Patenterteilung: **11.07.2018**
(21) Anmeldenummer: 08008713.3
(22) Anmeldetag: 09.05.2008
(51) Int. Cl.: H01L 23/498, H01L 23/373, H01L 21/48, H01L 23/00, H01L 25/07, H05K 3/06, H05K 1/03, H05K 3/12, H05K 3/24, C04B 37/02, C04B 35/645

(54) **Leistungshalbleitersubstrat mit Metallkontaktschicht sowie Herstellungsverfahren hierzu**
High performance semiconductor substrate with metal contact layer and corresponding production method
Substrat semi-conducteur de puissance doté d'une couche de contact métallique et procédé de fabrication associé

(30) Priorität: 12.05.2007 DE 102007022336
(43) Veröffentlichungstag der Anmeldung: 19.11.2008
(73) Patentinhaber: SEMIKRON Elektronik GmbH & Co. KG, 90431 Nürnberg (DE)
(72) Erfinder: Göbl, Christian, 90441 Nürnberg (DE); Braml, Heiko, Dr., 91346 Wiesenttal (DE)

(56) Entgegenhaltungen:
- DE-A1- 3 414 065
- DE-A1- 4 233 073
- DE-A1- 10 062 108
- DE-B3-102004 019 567
- US-A- 5 807 626
- US-A1- 2003 056 981

## Beschreibung

Die Erfindung beschreibt ein Leistungshalbleitersubstrat mit einem isolierenden Grundkörper, mindestens einer Leiterbahn und mindestens einer Kontaktfläche einer dieser Leiterbahnen. Derartige Leistungshalbleitersubstrate sind beispielhaft bekannt als AMD- (active metal braze), DCB- (direct copper bonding) oder IMS- (insulated metal substrat) Substrate.

Die Kontaktfläche, als Teil oder Abschnitt einer Leiterbahn, dient der elektrisch leitenden Verbindung beispielhaft mit Leistungshalbleiterbauelementen oder mit externen Verbindungselementen. Derartige Verbindungselemente können mit der Kontaktfläche beispielhaft mittels löttechnischer Verbindungen oder mittels druckkontaktierter Verbindungen ausgebildet sein. Speziell bei druckkontaktierten Verbindungen sind hier Verbindungen mit Kontaktfedern von besonderem Interesse.

Gemäß dem Stand der Technik sind DCB- Substrate bekannt, die aus einem keramischen Grundkörper, häufig Aluminiumoxid oder Aluminiumnitrid, mit hierauf angeordneten Leiterbahnen aus einer Kupferfolie. Derartige Leiterbahnen sind bevorzugt für löttechnische Verbindungen und bilden hierbei die Kontaktfläche selbst aus. Ebenso ist es bekannt einige oder alle Kontaktflächen mit einer zusätzliche dünnen Goldschicht, vorzugsweise mit einer Dicke von wenigen Atomlagen, auszubilden. Diese ist besonders für Kontaktflächen von Drahtbondverbindungen vorteilhaft. In Verbindung mit druckkontaktierten Anschlusselementen, wie Hilfs- oder Lastanschlusselemente von Leistungshalbleitermodulen, die gemäß dem Stand der Technik als Kontaktfedern ausgebildet sein können, sind diese Kontaktflächen nicht ausreichend. Durch die thermische Belastung, sowie die Druckbeaufschlagung können die Kontaktfüße der Kontaktfedern die dünne Goldschicht beschädigen und somit die Kontaktsicherheit beeinträchtigen.

Allgemein bekannt sind weiterhin, beispielhaft aus den Druckschriften DE 42 33 073 A1 Drucksinterverbindungen zweier Verbindungspartner, wie einer Leiterbahn und einem Leistungshalbleiterbauelement. In derartigen Verbindungen wird eine pastöse Schicht eines Sintermetalls, meist eine Mischung aus Edelmetallflocken und einem Lösungsmittel, zwischen den beiden Verbindungspartner angeordnet. Im Rahmen des Drucksinterverfahrens werden die beiden Verbindungspartner mittels der dazwischen angeordneten Schicht dauerhaft, stoffschlüssig verbunden.

Als Alternatives Verbindungsverfahren hierzu ist das sog. Active Metal Brazing (AMB-) Verfahren, beispielhaft aus der US 5,807,626 bekannt. Hierbei wird ein Isolierstoffkörper mit Leiterbahnen verbunden. Als Verbindungsmittel dient eine Mischung aus Silber und Kupfer, welches während des Verfahrens beispielhaft mittels Titan aktiviert wird.

Der Erfindung liegt die Aufgabe zugrunde ein Leistungshalbleitersubstrat mit verbesserten Kontakteigenschaften der Kontaktflächen speziell für druckkontaktierte Anwendungen vorzustellen, sowie ein einfaches und kostengünstiges Herstellungsverfahren für ein derartiges Leistungshalbleitersubstrat anzugeben.

Diese Aufgabe wird erfindungsgemäß gelöst, durch ein Leistungshalbleitersubstrat mit den Merkmale des Anspruchs 1 hergestellt mittels eines Verfahrens nach Anspruch 5. Bevorzugte Ausführungsformen sind in den Unteransprüchen beschrieben.

Ausgangspunkt der Erfindung ist ein Leistungshalbleitersubstrat mit einem isolierenden flächigen Grundkörper, mindestens einer Leiterbahn und mindestens einer Kontaktfläche als Teil dieser Leiterbahn. Erfindungsgemäß ist hierbei auf dieser Kontaktfläche eine vorzugsweise mindestens 10 Mikrometer dicke Schicht eines Werkstoffs mittels einer Drucksinterverbindung dieses metallischen Werkstoffs angeordnet. Wobei unter Drucksinterverbindung hier verstanden werden sollt, dass eine Schicht eines Werkstoffs mittels des im Weiteren genannten Verfahrens angeordnet wird. angeordnet. Wobei unter Drucksinterverbindung hier verstanden werden sollt, dass eine Schicht eines Werkstoffs mittels des im Weiteren genannten Verfahrens angeordnet wird.

Hierbei ist es bevorzugt, wenn der zweite metallische Werkstoff einen Anteil von mehr als 90 von 100 eines Edelmetalls aufweist. Besonders bevorzugt ist es hierbei, wenn dieses Edelmetall Silber ist.

Weiterhin kann es bevorzugt sein zwischen der Kontaktfläche und der metallischen Schicht eine weitere metallische Schicht eines Edelmetalls, vorzugsweise Gold, mit einer Schichtdicke von wenigen Atomlagen anzuordnen.

Das erfindungsgemäße Verfahren zur Herstellung eines derartigen Leistungshalbleitersubstrats weist folgende wesentliche Schritte auf:
- Herstellung eines Leistungshalbleitersubstrats mit einem flächigen isolierenden Grundkörper, Leiterbahnen und Kontaktflächen dieser Leiterbahnen;
- Anordnung einer pastösen Schicht, aus dem metallischen Werkstoffs und einem Lösungsmittel, auf mindestens einer Kontaktfläche des Leistungshalbleitersubstrats;
- Druckbeaufschlagung auf die pastöse Schicht. Hierbei ist es bevorzugt den überwiegenden Teil des Lösungsmittels vor der Druckbeaufschlagung aus der pastösen Schicht auszutreiben.

Es kann hierbei bevorzugt sein, wenn die pastöse Schicht mittels eines Schablonendruckverfahrens aufgebracht wird. Hierbei kann einerseits die notwendige Positioniergenauigkeit, bei der geforderten Schichtdicke, erreicht werden. Andererseits ist dieses Verfahren kostengünstig realisierbar.

Eine vorteilhafte Ausführung der Druckbeaufschlagung auf die pastöse Schicht kann durch die Anwendung einer Presse und zweier Pressstempel gegeben sein. Hierbei ist es zudem bevorzugt, wenn mindestens ein Pressstempel mit einem darauf angeordneten, einen quasihydrostatischen Druck erzeugenden Silikonkissen ausgebildet ist.

Hierbei ist es ebenfalls bevorzugt auf dem Leistungshalbleitersubstrat eine Folie, vorzugsweise eine Teflonfolie, anzuordnen und anschließend diesen Verbund mit Druck zu beaufschlagen.

Besonders bevorzugte Weiterbildungen dieses Leistungshalbleitersubstrats sowie des Herstellungsverfahrens sind in der jeweiligen Beschreibung der Ausführungsbeispiele genannt. Die erfinderische Lösung wird zudem an Hand der Ausführungsbeispiele der Fig. 1 bis 3 weiter erläutert.
Fig. 1 und 2 zeigen einzelne Schritte des erfindungsgemäßen Herstellungsverfahrens eines ersten erfindungsgemäßen Leistungshalbleitersubstrats.
Fig. 3 zeigt eine Anordnung mit einem zweiten erfindungsgemäßen Leistungshalbleitersubstrat.

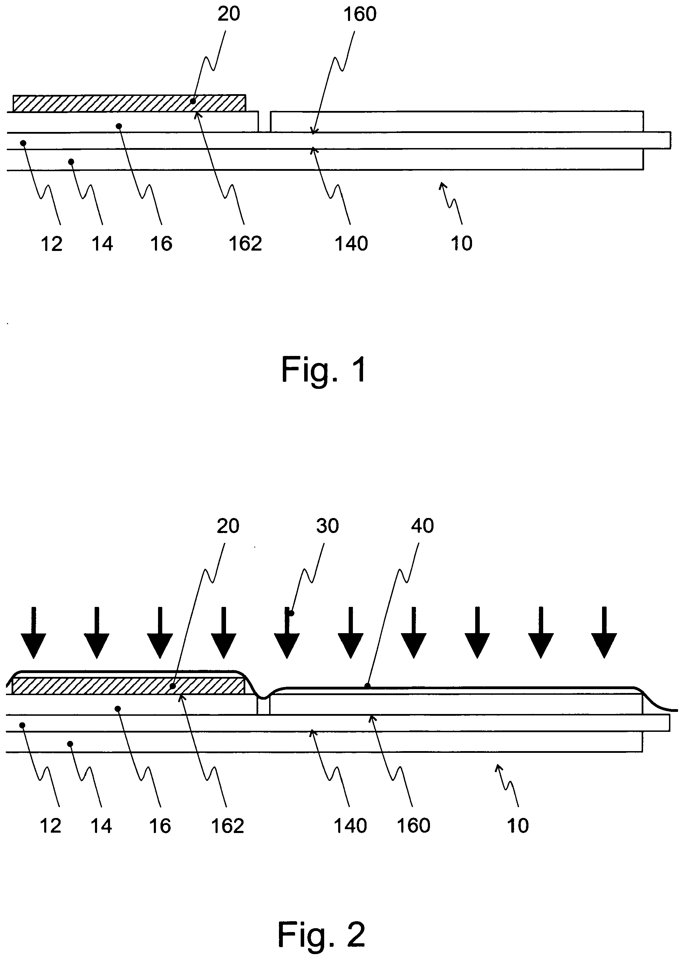

Fig. 1 und 2 zeigen einzelne Schritte des erfindungsgemäßen Herstellungsverfahrens eines ersten erfindungsgemäßen Leistungshalbleitersubstrats (10). In Fig. 1 ist ein Leistungshalbleitersubstrat (10) auf der Grundlage eines bekannten DCB- Substrats dargestellt. Dieses weist einen keramischen Grundkörper (12), mit einer Dicke von 250µm bis 700µm, aus Aluminiumoxid sowie auf den beiden Hauptflächen (140, 160) dieses Grundkörpers (12) angeordnete metallische Kaschierungen (14, 16) auf. Diese sind als Kupferfolien mit einer Dicke zwischen 200µm und 500µm ausgebildet. Die Kupferfolie (14) auf der ersten Hauptfläche (140) des Grundkörpers (12) ist flächig ausgebildet und dient dem thermischen Kontakt zu einem nicht dargestellten Kühlkörper. Die Kupferfolie (16) auf der zweiten Hauptfläche (160) des Grundkörpers (12) ist in sich strukturiert und bildet somit Leiterbahnen und auch die Kontaktflächen (162) selbst aus.

In anderen bevorzugten Ausgestaltungen können die Leiterbahnen in einem wesentlichen Teil ihres Verlaufs noch eine Abdeckschicht aufweisen. Die Kontaktflächen (162) weisen in derartigen Ausgestaltungen keine Abdeckung auf und können somit mit Halbleiterbauelementen, Verbindungs- oder Anschlusselementen verbunden werden.

Gemäß dem erfindungsgemäßen Verfahren wird in einem ersten nicht explizit dargestellten Schritt, vorzugsweise mittels Schablonendrucktechnik, eine pastöse Schicht (20), wie sie aus Sinterverbindungen nach dem Stand der Technik bekannt ist, auf einer Kontaktfläche (162) oder einem Teil einer Leiterbahn angeordnet. Hierbei ist es besonders bevorzugt, wenn die Schichtdicke dieser pastösen Schicht zwischen 10µm und 200µm beträgt.

Die pastöse Schicht (20) selbst besteht aus einer Mischung eines metallischen Werkstoffs in Form von Metallflocken mit einer maximalen Ausdehnung in der Größenordnung von Mikrometern und einem Lösungsmittel. Als Material der Metallflocken eignet sich besonders Silber, aber auch andere Edelmetalle oder Mischungen mit einem Edelmetallanteil von mehr als 90 von 100.

Fig. 2 zeigt die Druckbeaufschlagung (30) auf die pastöse Schicht (20) zur Ausbildung einer metallischen Schicht. Vor dieser Druckbeaufschlagung (30) ist es vorteilhaft das Lösungsmittel zu mindestens 95 von 100 aus der pastösen Schicht (20) auszutreiben. Dies wird bevorzugt mittels Temperaturbeaufschlagung auf das Leistungshalbleitersubstrat (10) erreicht. Diese Erwärmung auf mindestens 350K wird auch während der anschließenden Druckbeaufschlagung (30) beibehalten oder noch erhöht.

Zusätzlich dargestellt und auch bevorzugt ist hier eine Folie (40), beispielhaft eine Teflonfolie, die vor der Druckbeaufschlagung (30) aufgebracht wurde. Hierbei ist es bevorzugt das gesamte Leistungshalbleitersubstrat (10) abzudecken. Es ist allerdings in manchen Ausbildungen möglich selektiv nur die jeweilige pastöse Schicht (20) mit der Folie (30) zu bedecken.

Um eine ausreichend haftende Verbindung zwischen der pastösen Schicht (20) und der Kontaktfläche (162) auszubilden ist es bevorzugt, wenn der maximale Enddruck bei der Druckbeaufschlagung (30) mindestens 8MPa entspricht.

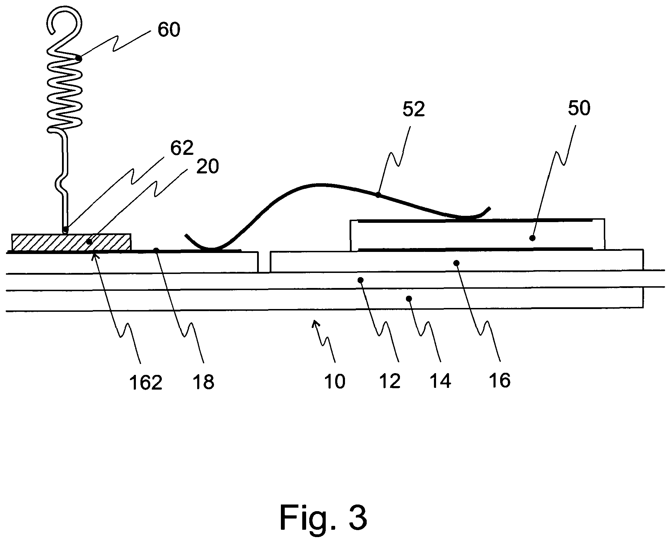

Fig. 3 zeigt eine Anordnung mit einem zweiten erfindungsgemäßen Leistungshalbleitersubstrat (10), einem Leistungshalbleiterbauelement (50) und einer Kontaktfeder (60). Das Leistungshalbleitersubstrat (10) ist wiederum wie in Fig. 1 beschrieben ein DCB- Substrat. Auf einer Leiterbahn (16) dieses Substrats ist ein Leistungshalbleiterbauelement (50), hier eine Leistungsdiode, angeordnet und mit der Leiterbahn (16) löttechnisch verbunden, wobei hier diese Verbindungsvariante nicht als Beschränkung zu verstehen ist.

Die Leistungsdiode (50) ist weiterhin mittels einer ebenfalls nicht einschränkenden Drahtbondverbindung (52) mit einer zweiten Leiterbahn (16) verbunden. Diese zweite Leiterbahn weist im Bereich der Kontaktfläche (162) eine dünne Goldschicht (18) mit einer Dicke im Bereich einiger Atomlagen auf um den elektrischen Kontakt zum Bonddraht (52) zu verbessern. Auf der Goldschicht (18) ist erfindungsgemäß eine metallische Schicht (20), nach dem oben beschriebenen Verfahren angeordnet. Diese Schicht (20) ist eine Silberschicht und weist ein Dicke von mehr als 10µm auf. Ebenso geeignet sind andere Werkstoffe, vorzugsweise mit einem Anteil eines Edelmetalls von mehr als 90 von 100.

Ebenfalls dargestellt ist eine Kontaktfeder (60), wie sie für druckkontaktierte Anschlusselemente bekannte ist. Deren Kontaktfuß (62) ist mit der metallischen Schicht (20) in Verbindung und stellte den Kontakt eines nach außen, beispielhaft aus einem Leistungshalbleitermodul heraus, führenden Anschlusselements dar.

Ein Vorteil des erfindungsgemäßen Leistungshalbleitersubstrats (10) ist es, dass durch die Dicke der metallischen Schicht (20) von mehr als 10µm, vorzugsweise von mehr als 50µm eine hervorragende Kontaktfläche ausgebildet wird, um in Kombination mit druckkontaktierten Kontaktfedern (60) dauerhafte und qualitativ sehr hochwertige Verbindungen auszubilden.

Die erfindungsgemäße Herstellung entspricht hinsichtlich der benötigten Materialien, wie auch der notwendigen Anlagen einer Drucksinterverbindung dem Stand der Technik. Hierdurch ist die Herstellung eines derartigen Leistungshalbleitersubstrats (10) besonders vorteilhaft, weil einfach und kostengünstig, möglich.

## Patentansprüche

1. Leistungshalbleitersubstrat (10) mit einem isolierenden flächigen Grundkörper (12), mindestens einer Leiterbahn (16) und mindestens einer Kontaktfläche (162) als Teil dieser Leiterbahn (16), wobei auf dieser Kontaktfläche (162) eine Schicht (20) eines Werkstoffs mittels einer Drucksinterverbindung dieses metallischen Werkstoffs angeordnet ist und wobei die metallische Schicht (20) auf ihrer Oberseite eine Kontaktfläche ausbildet, mit der kein Bauelement sintertechnisch verbunden ist.

2. Leistungshalbleitersubstrat nach Anspruch 1,
wobei der metallische Werkstoff eine Schichtdicke von mindestens 10 Mikrometern und einen Anteil von mehr als 90 von 100 eines Edelmetalls aufweist.

3. Leistungshalbleitersubstrat nach Anspruch 2,
wobei das Edelmetall Silber ist.

4. Leistungshalbleitersubstrat nach Anspruch 1,
wobei zwischen der Kontaktfläche (162) und der metallischen Schicht (20) eine weitere metallische Schicht (18) eines Edelmetalls mit einer Schichtdicke von wenigen Atomlagen angeordnet ist.

5. Verfahren zur Herstellung eines Leistungshalbleitersubstrats (10) nach Anspruch 1 mit den wesentlichen Schritten:
a) Herstellung eines Leistungshalbleitersubstrats mit einem flächigen isolierenden Grundkörper (12), Leiterbahnen (16) und Kontaktflächen (162) als Teil dieser Leiterbahnen (16);
b) Anordnung einer pastösen Schicht (20), aus einem metallischen Werkstoff und einem Lösungsmittel, auf mindestens einer Kontaktfläche (162) des Leistungshalbleitersubstrats (10);
c) Druckbeaufschlagung (30) auf die pastöse Schicht (20) unter Ausbildung einer metallischen Schicht, die auf ihrer Oberseite eine Kontaktfläche aufweist, mit der kein Bauelement sintertechnisch verbunden ist.

6. Verfahren nach Anspruch 5,
wobei die pastöse Schicht (20) mittels eines Schablonendruckverfahrens aufgebracht wird.

7. Verfahren nach Anspruch 5,
wobei der Druck (30) mittels einer Presse und zweier Pressstempel, wobei mindestens ein Pressstempel mit einem darauf angeordneten, einen quasihydrostatischen Druck erzeugendes Silikonkissen ausgebildet ist, aufgebracht wird.

8. Verfahren nach Anspruch 5,
wobei der maximale Enddruck bei der Druckbeaufschlagung (30) mindestens 8MPa entspricht.

9. Verfahren nach Anspruch 5,
wobei während der Druckbeaufschlagung (30) das Leistungshalbleitersubstrat (10) auf mehr als 350K erwärmt ist.

10. Verfahren nach Anspruch 5,
wobei vor der Druckbeaufschlagung (30) das Leistungshalbleitersubstrat (10) mit einer Folie (40) bedeckt wird.

## Claims

1. Power semiconductor substrate (10) comprising an insulating planar base body (12), at least one conductor track (16) and at least one contact area (162) as part of said conductor track (16), wherein a layer (20) of a material is arranged on said contact area (162) by means of a pressure sintering connection of this metallic material and wherein the metallic layer (20) forms a contact area on its top side, to which no component is connected by sintering technology.

2. Power semiconductor substrate according to Claim 1,
wherein the metallic material has a layer thickness of at least 10 micrometers and a proportion of more than 90 per cent of a noble metal.

3. Power semiconductor substrate according to Claim 2,
wherein the noble metal is silver.

4. Power semiconductor substrate according to Claim 1,
wherein a further metallic layer (18) of a noble metal having a layer thickness of a few atomic layers is arranged between the contact area (162) and the metallic layer (20).

5. Method for producing a power semiconductor substrate (10) according to Claim 1, comprising the essential steps of:
a) Producing a power semiconductor substrate comprising a planar insulating base body (12), conductor tracks (16) and contact areas (162) as part of said conductor tracks (16);
b) Arranging a pasty layer (20), composed of a metallic material and a solvent, on at least one contact area (162) of the power semiconductor substrate (10);
c) Applying pressure (30) to the pasty layer (20) to form a metallic layer which a contact area on its top side, to which no component is connected by sintering technology.

6. Method according to Claim 5,
wherein the pasty layer (20) is applied by means of a stencil printing method.

7. Method according to Claim 5,
wherein the pressure (30) is applied by means of a press and two pressing rams, wherein at least one pressing ram is formed with a silicone pad which generates a quasi-hydrostatic pressure arranged on it.

8. Method according to Claim 5,
wherein the maximum end pressure when applying pressure (30) corresponds to at least 8 MPa.

9. Method according to Claim 5,
wherein the power semiconductor substrate (10) is heated to more than 350 K during the application of pressure (30).

10. Method according to Claim 5,
wherein the power semiconductor substrate (10) is covered with a film (40) prior to the application of pressure (30).

## Revendications

1. Substrat semi-conducteur de puissance (10) comprenant un corps de base plat isolant (12), au moins une piste conductrice (16) et au moins une surface de contact (162) en tant que partie de cette piste conductrice (16), une couche (20) d'un matériau étant agencée sur cette surface de contact (162) au moyen d'une liaison par frittage sous pression de ce matériau métallique et la couche métallique (20) formant sur son côté supérieur une surface de contact avec laquelle aucun élément de construction n'est relié par frittage.

2. Substrat semi-conducteur de puissance selon la revendication 1, dans lequel le matériau métallique présente une épaisseur de couche d'au moins 10 micromètres et une proportion de plus de 90 sur 100 d'un métal noble.

3. Substrat semi-conducteur de puissance selon la revendication 2, dans lequel le métal noble est l'argent.

4. Substrat semi-conducteur de puissance selon la revendication 1, dans lequel une couche métallique supplémentaire (18) d'un métal noble d'une épaisseur de couche de quelques couches atomiques est agencée entre la surface de contact (162) et la couche métallique (20).

5. Procédé de fabrication d'un substrat semi-conducteur de puissance (10) selon la revendication 1, comprenant les étapes essentielles suivantes :
a) la fabrication d'un substrat semi-conducteur de puissance comprenant un corps de base isolant plat (12), des pistes conductrices (16) et des surfaces de contact (162) en tant que partie de ces pistes conductrices (16) ;
b) l'agencement d'une couche pâteuse (20), constituée par un matériau métallique et un solvant, sur au moins une surface de contact (162) du substrat semi-conducteur de puissance (10) ;
c) l'application d'une pression (30) sur la couche pâteuse (20) avec formation d'une couche métallique qui comprend sur son côté supérieur une surface de contact avec laquelle aucun élément de construction n'est relié par frittage.

6. Procédé selon la revendication 5, dans lequel la couche pâteuse (20) est appliquée par un procédé d'impression au pochoir.

7. Procédé selon la revendication 5, dans lequel la pression (30) est appliquée au moyen d'une presse et de deux poinçons, au moins un poinçon étant configuré avec un coussin de silicone agencé sur celui-ci, générant une pression quasi-hydrostatique.

8. Procédé selon la revendication 5, dans lequel la pression finale maximale lors de l'application de pression (30) correspond à au moins 8 MPa.

9. Procédé selon la revendication 5, dans lequel le substrat semi-conducteur de puissance (10) est porté à plus de 350 K pendant l'application de pression (30).

10. Procédé selon la revendication 5, dans lequel le substrat semi-conducteur de puissance (10) est recouvert avec une feuille (40) avant l'application de pression (30) .
